Europäisches Patentamt

European Patent Office

Office européen des brevets

(11) Publication number: 0 608 581 A1

# EUROPEAN PATENT APPLICATION

(21) Application number: 93203178.4

(51) Int. Cl.5: **B60S 1/08**, H02K 11/00

(22) Date of filing: 15.11.93

(30) Priority: 23.01.93 GB 9301332

(43) Date of publication of application:
03.08.94 Bulletin 94/31

(84) Designated Contracting States:
DE ES FR IT

(71) Applicant: AUTOMOTIVE COMPONENTS
DUNSTABLE LIMITED
High Street North
Dunstable Bedfordshire LU6 1UZ(GB)

(72) Inventor: Bates, Trevor
25 Bibshall Crescent
Dunstable, Bedfordshire LU6 3NF(GB)

(74) Representative: Britter, Keith Palmer et al
Britter & Co
Barn West - Dixies
High Street - Ashwell Hertfordshire SG7 5NT
(GB)

(54) Interference suppression circuit.

(57) An interference suppression circuit for a two-speed electrical motor (10) includes an inductance (L2) coupled to a low speed motor brush (12), an inductance (L1) coupled to a high speed motor brush (14), a capacitance (C2) coupled between the inductance (L2) and ground and a capacitance (C1) coupled between the inductance (L1) and ground. A third capacitance (C3) is coupled between the low and high speed brushes. The third capacitance (C3) provides a surprising increase in attenuation of radio frequency interference.

Fig.2.

EP 0 608 581 A1

The present invention relates to an interference suppression circuit for a two-speed motor.

In a two-speed motor for a vehicle windscreen wiper system it is generally necessary to provide an interference suppression circuit to attenuate interference to the vehicle radio caused during operation of the motor. Such a circuit generally consists of two chokes, each connected between a respective low or high speed motor brush and the vehicle power supply, and two capacitors, each connected between a respective motor brush and ground. In use, the chokes provide suppression at the higher broadcast frequencies while the capacitors, which typically have a capacitance of 1.0$\mu$F, provide suppression at the lower broadcast frequencies.

In some situations, such as in countries which have predominantly Long Wave and Medium Wave broadcasts and in which the signal strengths are weak, there is the need for additional interference suppression, possibly a further 10 to 15 dB, to give acceptable radio performance.

In these situations, increasing the capacitance of the interference suppression capacitors can give the required suppression. For example, a 2.0$\mu$F capacitor will attenuate such interference by a further 6 dB, while a 4.0$\mu$F capacitor will provide 12 dB additional attenuation. However, such capacitors are physically large and often too large to fit within the confined space in an electrical motor, particularly a vehicle windscreen wiper motor. Electrolytic and ceramic capacitors, which are physically smaller, generally can not withstand the high temperatures and high transient voltages experienced in these types of motor.

The present invention seeks to provide an improved interference suppression circuit for a two-speed electrical motor.

According to an aspect of the present invention, there is provided an interference suppression circuit for use with a two-speed electrical motor as specified in claim 1.

Contrary to theoretical calculations, it has been found that the provision of a third capacitance between the two supply brushes can give a significant amount of attenuation in addition to the attenuation normally provided by first and second capacitances coupled between respective supply brushes and ground.

Preferably, the third capacitance is connected such that first and second inductances are disposed electrically between the first and second supply brushes and the third capacitance. This arrangement enables the third capacitance to be placed outside the motor casing.

Alternatively, the third capacitance may be disposed electrically between the first and second inductances and the first and second supply brushes.

In an embodiment, there is provided a switch connected to the first and second inductances for selectively connecting the first and second supply brushes to a power source. This enables the motor to be operated from a single power source.

Preferably, each of the first, second and third capacitances has a value of 1.0$\mu$F.

The present invention is also directed to a two-speed electrical motor comprising first and second supply brushes and an interference suppression circuit of the above type.

An embodiment of the present invention is described below, by way of illustration only, with reference to the accompanying drawing, in which:

Figure 1 shows a prior art interference suppression circuit connected to a two-speed electrical motor;

Figure 2 shows an embodiment of interference suppression circuit connected to a two-speed electrical motor; and

Figure 3 is a view of a theoretical equivalent circuit of the circuit of Figure 2 when operating at a frequency of 150kHz.

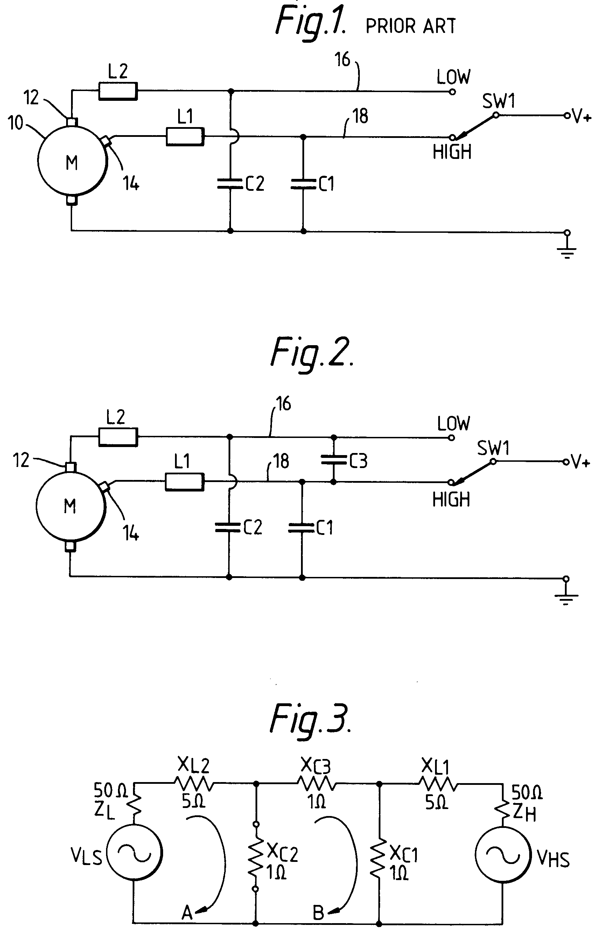

Referring to Figure 1, a prior art interference suppression circuit is shown connected to a two-speed electrical motor 10 which includes a low speed supply brush 12 connected by a conductor 16 to a first terminal of a switch SW1 through an interference suppression choke L2. A high speed supply brush 14 is connected by a conductor 18 to a second terminal of switch SW1 through an interference suppression choke L1, while a ground brush is connected directly to ground. Two capacitors C1,C2 are also provided for suppressing lower frequency interference, capacitor C1 being coupled to conductor 18 connecting the high speed brush 14 to the second terminal of switch SW1 and to ground, while capacitor C2 is coupled to conductor 16 connecting the low speed brush 12 to the first terminal of switch SW1 and to ground.

Switch SW1 is connected to a voltage supply V$^+$ and selectively couples one of the motor brushes 12,14 of the motor 10 to the power supply so as to drive the motor at one of two-speeds.

Referring now to Figure 2 which shows an embodiment of interference suppression circuit. As can be seen, this embodiment includes two chokes L1,L2, two capacitors C1,C2 and a switch SW1 arranged as in the circuit of Figure 1.

A third interference suppression capacitor C3 is connected between conductors 16,18 coupling the low and high speed brushes 12,14 to the switch SW1. The third capacitor C3 is connected such that the two chokes L1,L2 lie electrically between the capacitor C3 and the low and high speed supply brushes 12,14. In this example, all three interference suppression capacitors C1,C2,C3 have a capacitance of 1.0µF.

In use, when the switch SW1 is switched to connect the high speed brush 14 of the motor 10 to the power supply V⁺, the capacitors C1-C3 are coupled in such a manner that the third capacitor C3 is connected in series with capacitor C2 and in parallel with capacitor C1. Thus, theoretically, the overall capacitance becomes 1.5µF in the case where each capacitor C1-C3 has a capacitance of 1.0µF. The situation is similar when the low speed supply brush 12 is connected to the power supply V⁺.

The theoretical improvement obtainable from the circuit of Figure 2 when operating at a frequency of 150kHz, can be derived on the basis of the theoretical equivalent circuit shown in Figure 3. This theoretical equivalent circuit is readily derivable by the skilled person and shows the reactance values of the capacitors and chokes at 150kHz. At this frequency, the chokes used in this example have a reactance of approximately 5Ω, while each capacitor has a reactance of approximately 1Ω.

With the prior art circuit of Figure 1 above, the theoretical equivalent circuit is shown as loop A in Figure 3 and provides an attenuation of:

$$20 * \mathrm{LOG}\left(1/(55 + 1)\right) = 35\mathrm{dB}.$$

On the other hand, with the addition of capacitor C3, the theoretical circuit formed by loops A and B in Figure 3, ignoring the effect of the impedance Zh on the basis that it is too high to affect the capacitor C1, provides an attenuation of:

$$20 * \mathrm{LOG}\left(0.66/(55 + 0.66)\right) = 38 \text{ dB}.$$

Although the theoretical improvement in attenuation of 3 dB provided by such a circuit is insufficient to warrant pursuing such a solution, in tests the measured improvement in suppression has been of the order of 10 to 12 dB, which is equivalent to a prior art circuit which uses two capacitors of 4.0µF each.

The reason for the measured improvement being so much more than the theoretical improvement is not known. It may be due to the effect of complex radio frequency currents flowing through the circuit as a result of the third capacitor C3.

In an alternative embodiment, the third capacitor C3 may be located electrically adjacent the motor supply brushes 12,14, in other words between the chokes L1,L2 and the motor supply brushes 12,14.

It will be apparent that the capacitors C1,C2 and C3 may have any suitable values, depending upon the particular application and particular suppression requirements. It is not necessary for the capacitors C1,C2 and C3 to have equal capacitances.

The disclosures in British patent application no. 9301332.4, from which this application claims priority, and in the abstract accompanying this application are incorporated herein by reference.

**Claims**

1. An interference suppression circuit for use with a two-speed electrical motor including first and second supply brushes connectable selectively to a power source; the circuit comprising first and second inductances (L1,L2) each connected to a respective supply brush (12,14) of a motor and connectable to a power source; first and second capacitances (C1,C2) each connected to a respective supply brush and to ground; and a third capacitance (C3) connected between the first and second supply brushes.

2. An interference suppression circuit according to claim 1, wherein the third capacitance is connected such that the first and second inductances are disposed electrically between the first and second supply brushes and the third capacitance.

3. An interference suppression circuit according to claim 1, wherein the third capacitance is disposed electrically between the first and second inductances and the first and second supply brushes.

4. An interference suppression circuit according to claim 1, 2 or 3, comprising a switch (SW1) connected to the first and second inductances for selectively connecting the first and second supply brushes to a power source.

5. An interference suppression circuit according to any preceding claim, wherein each of the first, second and third capacitances has a value of 1.0$\mu$F.

6. A two-speed electrical motor comprising first and second supply brushes (12,14) and an interference suppression circuit according to any preceding claim.

*Fig.1.* PRIOR ART

*Fig.2.*

*Fig.3.*

## DOCUMENTS CONSIDERED TO BE RELEVANT

| Category | Citation of document with indication, where appropriate, of relevant passages | Relevant to claim | CLASSIFICATION OF THE APPLICATION (Int.Cl.5) |
|---|---|---|---|
| X | WO-A-91 03856 (SWF) | 1,2,4,6 | B60S1/08 |
| Y | * claims 1,15; figure 10 * | 3,5 | H02K11/00 |
|  | * page 11, line 15 - line 25 * | | |
|  | --- | | |
| Y | J.E.E. JOURNAL OF ELECTRONIC ENGINEERS vol. 23, no. 235 , July 1986 , TOKYO, JP pages 44 - 48 SASAI 'Automobile Electric Motors and Their Applications' | 3 | |
| A | * figure 5 * | 1,4,6 | |
|  | --- | | |
| Y | GB-A-2 256 982 (DELCO CHASSIS OVERSEAS CORP.) | 5 | |
| A | * figure 1 * | 1,4,6 | |
|  | * page 1, line 4 - line 34 * | | |
|  | * page 4, line 24 - page 6, line 9 * | | |
|  | --- | | |
| A | EP-A-0 336 530 (DELCO PRODUCTS OVERSEAS CORP.) | 1,2,4-6 | |
|  | * abstract; claim 1; figures 1,2 * | | |
|  | * column 1, line 1 - column 2, line 6 * | | TECHNICAL FIELDS SEARCHED (Int.Cl.5) |
|  | * column 2, line 40 - column 3, line 33 * | | |
|  | ----- | | B60S |
|  | | | H02K |

The present search report has been drawn up for all claims

| Place of search | Date of completion of the search | Examiner |
|---|---|---|
| THE HAGUE | 18 April 1994 | WESTLAND, P |

CATEGORY OF CITED DOCUMENTS

X : particularly relevant if taken alone
Y : particularly relevant if combined with another
document of the same category
A : technological background
O : non-written disclosure
P : intermediate document

T : theory or principle underlying the invention
E : earlier patent document, but published on, or
after the filing date
D : document cited in the application
L : document cited for other reasons

...................................................................

& : member of the same patent family, corresponding
document

EPO FORM 1503 03.82 (P04C01)